# EUROPÄISCHE PATENTSCHRIFT

(11) **EP 1 603 722 B1**
(45) Veröffentlichungstag und Bekanntmachung des Hinweises auf die Patenterteilung: **16.09.2009**
(21) Anmeldenummer: 04720594.3
(22) Anmeldetag: 15.03.2004
(51) Int. Cl.: B28D 5/00, H05K 3/00

(54) **BRECHVORRICHTUNG FüR DAS VEREINZELN VON KERAMIKLEITERPLATTEN**
BREAKING DEVICE FOR SEPARATING CERAMIC PRINTED CIRCUIT BOARDS
DISPOSITIF DE CISAILLEMENT SERVANT A SEPARER DES CARTES DE CIRCUITS IMPRIMES EN CERAMIQUE

(30) Priorität: 17.03.2003 DE 10311692; 28.03.2003 DE 10314179
(43) Veröffentlichungstag der Anmeldung: 14.12.2005
(73) Patentinhaber: Baumann Gmbh, 92224 Amberg (DE)
(72) Erfinder: KONRAD, Josef, 92694 Etzenricht (DE); KREDLER, Gerhard, 92249 Vilseck (DE)
(74) Vertreter: Klunker . Schmitt-Nilson . Hirsch
(86) Internationale Anmeldenummer: PCT/EP2004/002677
(87) Internationale Veröffentlichungsnummer: WO 2004/082911

(56) Entgegenhaltungen:
- WO-A-03/002471
- DE-A- 10 007 642
- FR-A- 2 729 885
- US-A- 5 069 195

## Beschreibung

Die vorliegende Erfindung betrifft eine Brechvorrichtung für das Vereinzeln von Keramikleiterplatten entlang von Schwächungslinien auf einer Keramikleiterplatte gemäß dem Oberbegriff des Anspruchs 1, und zwei Verfahren zum Vereinzeln von Keramikleiterplatten gemäß dem Oberbegriff der Ansprüche 13 und 15.

Eine Solche Vorrichtung und solchen Verfahren sind aus WO 03/002471 A1 bekannt.

Eine derartige Brechvorrichtung ist auch aus US-A-5 069 195 bekannt. Insbesondere weist die in dieser Schrift beschriebene Brechvorrichtung ein Vielzahl von relativ zueinander verlagerbaren Auflageplatten auf, die an einer Vielzahl von parallelen und rechtwinkligen Bruchlinien aneinander grenzen und miteinander verbunden sind. Eine Anordnung aus einer Vielzahl von beispielsweise federbelasteten Stempeln ist über den Auflageplatten vorgesehen, so dass für jede Auflageplatte ein Stempel vorgesehen ist. Ferner ist eine relativ komplizierte Antriebsvorrichtung vorgesehen, mittels derer die einzelnen Auflageplatten relativ zueinander verlagert werden können. Im Betrieb wird eine Keramikleiterplatte auf der Brechfalle positioniert, die Stempelanordnung nach unten gefahren, so dass jeder Stempel mit einer bestimmten Vorspannung gegen die Keramikleiterplatte drückt. Im weiteren Verlauf werden die einzelnen Auflageplatten relativ zueinander bewegt, wobei die Stempel sicherstellen, dass die Keramikleiterplatte entlang der Bruchlinien knickt und bricht. Dabei pressen die Stempel zentral auf die einzelnen Hybridschaltungen. Dabei besteht ein sehr hohes Risiko einer Beschädigung der darauf angebrachten elektronischen Bauteile bzw. der Hybridschaltung als Ganzes. Eine Niederhaltevorrichtung mit derartigen Stempeln ist deshalb höchst unerwünscht.

Derartige Brechvorrichtungen werden für das Vereinzeln von sog. Hybridschaltungen verwendet. Dabei handelt es sich um elektronische Bauelemente auf Keramiksubstraten, wie sie insbesondere für Hochtemperaturanwendungen, beispielsweise als Motorsteuerungen in den Motorräumen von Kraftfahrzeugen oder als Motorsteuerungen für Elektromotoren, verwendet werden. Häufig sind Leiterbahnen und/oder Widerstände im Druckverfahren auf die Oberflächen der Substrate aufgebracht, während die elektronischen Bauteile im SMD-Verfahren aufgebracht und verlötet werden. Häufig wird dabei mit "offenen" elektronischen Bauteilen, wie beispielsweise Prozessoren, gearbeitet, die auf der Oberfläche der Keramiksubstrate angebracht und gebondet werden und erst im Anschluss daran beispielsweise mit einem Harz vergossen werden. Entsprechend empfindlich sind derartige Hybridschaltungen. Entsprechend ist es ein Nachteil von US-A-5 069 195, zentral auf die Hybridschaltungen einen von der FederKraft vorgespannten Stempel aufzusetzen. Es besteht die Gefahr, dass einzelne Bauteile oder Lötverbindungen beschädigt werden. Ein weiterer Nachteil bei US-A-5 069 195 besteht darin, dass nur Hybridschaltungen gleicher Größe mit dieser Brechvorrichtung gebrochen werden können, da die Auflageplattengröße das Rastermaß der Hybridschaltungen vorgibt, die gebrochen werden können. Ein Umrüsten ist praktisch nicht oder nur mit erheblichem Aufwand möglich.

In der Praxis ist es so, dass weit über 90% der Keramikleiterplatten von Hand gebrochen werden. Die Schwächungslinien sind grundsätzlich entweder geritzt, beispielsweise mittels eines Diamanten, oder in der Art einer Perforierung, die typischerweise nicht durch das Substrat hindurch geht, von einem Laser hergestellt. Es gibt deshalb eine Vorzugsrichtung für das Brechen je nachdem auf welcher Seite der Keramikleiterplatte die Schwächungslinie aufgebracht wurde. Diese Vorzugsrichtung wird nachfolgend als "Bruchrichtung" bezeichnet. Der Grund dafür, dass immer noch ein sehr großer Anteil dieser Keramikleiterplatten von Hand vereinzelt wird, liegt daran, dass das maschinelle Brechen dieses spröden Materials häufig zu viel Ausschuss produziert, weil kleinste Beschädigungen die komplette Zerstörung einer Keramikleiterplatte mit den gesamten zu vereinzelnden Hybridsubstraten zur Folge haben können. Da die einzelnen Hybridschaltungen in der Regel sehr teuer sind, ist ein derartiger Ausschuss nicht tolerabel.

Bei derartigen Keramikmaterialien treten typischerweise beim Brechen zwei unterschiedliche Fehler auf. Das sind zum einen "wilde Brüche" und zum anderen "Muschelbrüche". Wilde Brüche laufen wild über das Substrat, unabhängig von den vorgegebenen Schwächungslinien. Das Keramikmaterial ist kein homogenes Material, wodurch solche wilden Brüche begünstigt werden. Muschelbrüche sind Ausbrüche oder Abplatzungen an den Bruchkanten. Es ist offensichtlich, dass bei wilden Brüchen die betroffenen Hybridschaltungen untauglich werden. Muschelbrüche führen häufig nicht zu einem Sofortausfall, sondern zu einem Ausfall im Betrieb lange vor der eigentlichen Lebensdauer. Zur Vermeidung derartiger Fehlbrüche ist es höchst wünschenswert, die Brechkräfte lokal auf die zu brechende Schwächungslinie aufzubringen und nicht irgendwo auf eine Hybridschaltung.

In DE 299 19 961 U1 und DE 100 07 64.2 A1 ist eine Brechvorrichtung beschrieben, wie sie nach der Kenntnis der sachkundigen Anmelderin als eine der wenigen tatsächlich in nennenswertem Umfang zur Vereinzelung von Keramikleiterplatten eingesetzt wird. Diese Brechvorrichtung weist eine elastisch nachgiebige, durchgehende Auflageplatte auf, die beispielsweise aus einem Gummimaterial gebildet ist. Zum sicheren Festhalten der Keramikleiterplatten ist hier an Stelle der Stempelanordnung aus US-A-5 069 195 eine Saugvorrichtung vorgesehen, die mehrere Reihen von reihenweise gemeinsam geschalteten Saugöffnungen aufweist, wobei jeweils für eine einzelne Hybridschaltung an der Keramikleiterplatte eine Saugöffnung vorgesehen ist. Ein von einem Roboterarm manipuliertes Brechschwert wird über der zu brechenden Schwächungslinie positioniert und dann nach unten gefahren. Es drückt gegen die Schwächungslinie und drückt an dieser Schwächungslinie die Keramikleiterplatte gegen die Gummiauflage, bis sie bricht. Beim Brechen wird schlagartig die in der Gummiauflage gespeicherte Energie frei, was zusätzliche Kräfte und ggf. in Folge davon Brüche in die Keramikleiterplatten einbringt. Aus einer Keramikleiterplatte werden so in einem ersten Brechschritt eine Mehrzahl von länglichen Reihen aus mehreren in einer Reihe angeordneten Hybridschaltungen herausgebrochen. Diese Schaltungen müssen gegriffen werden und zu einer weiteren Vereinzelungsstation transportiert werden, an denen diese entlang der Schwächungslinien, die in Längsrichtung nacheinander auf dieser Reihe vorgesehen sind, noch gebrochen werden, um die einzelnen Hybridschaltungen voneinander zu separieren. Diese zweite Brechvorrichtung funktioniert prinzipiell genauso wie die erste und ist in entsprechender Weise aufgebaut. Ein Problem besteht in dem Transport der Reihen von Hybridschaltungen von der ersten Brechvorrichtung zur zweiten Brechvorrichtung. Die Reihen können nicht von ihren Längsseiten her gegriffen werden, da zwischen den einzelnen Bruchstücken der Keramikleiterplatte keine Spalte vorhanden sind, in die ein Greifer greifen könnte. Entsprechend müssen die Reihen von ihren Enden her gegriffen werden. Bei diesen Brechvorrichtungen kommt es jedoch häufig zu Brüchen quer zur Reihe, so dass die Reihe nicht an den Längsenden gegriffen werden kann und zur nächsten Brechvorrichtung transportiert werden kann. Eine solche nicht ordnungsgemäß verarbeitete Reihe muss beilspielsweise von Hand nachgeführt werden.

Mit dieser beschriebenen Brechvorrichtung aus dem Stand der Technik lassen sich Hybridschaltungen einer gewissen Größe relativ problemlos vereinzeln. Auch sind die dabei auftretenden Ausfälle in einem tolerablen Rahmen. Ein Nachteil dieser Brechvorrichtung liegt jedoch darin, dass sie für bestimmte Hybridschaltungsgrößen ausgelegt ist. Hybridschaltungen, die deutlich andere Maße haben, müssen jedoch auf speziellen Brechvorrichtungen gebrochen werden, da die Ventilanordnungen etc. nicht mehr kompatibel sind. Ein Umrüsten auf andere Hybridschaltungsformate ist deshalb bei dieser Vorrichtung nicht problemlos möglich. Außerdem treten Probleme auf, wenn die einzelnen Hybridschaltungen zu klein, z.B. kleiner als 15 mm in einer Richtung, werden. In Folge der Nachgiebigkeit der Unterlage müssen dann relativ hohe Kräfte zum Brechen der Hybridschaltungen auf die Schwächungslinien aufgebracht werden. Je kleiner die Hybridschaltungen werden, umso größer werden auch die Kräfte, die frei werden, wenn das elastische Material sich nach dem Brechen wieder in seine Ausgangsposition zurück bewegt. Es kann dazu kommen, dass die Saugkräfte nicht mehr ausreichend sind, vereinzelte Reihen an der Unterlage festzuhalten, und die einzelnen Hybridschaltungen können infolgedessen unkontrolliert brechen und auf der Auflagefläche verteilt sein.

Sämtlichen Brechvorrichtungen des Stands der Technik ist gemeinsam, dass sie nur in eine Richtung brechen können, d.h. relativ zu den obenauf der Keramikleiterplatte angebrachten elektronischen Bauteilen wird immer in die gleiche Richtung gebrochen. So erfolgt bei US-A-5 069 195 ein Brechen, indem ein Teil der Keramikleiterplatte nach unten geknickt wird, während bei DE 299 19 961 U1 und DE 100 07 642 A1 ein Brechen erfolgt, indem die beiden Bruchstücke der Keramikleiterplatte relativ zueinander nach oben geknickt werden. Vorangehend wurde bereits geschildert, wie die Schwächungslinien auf den Keramikleiterplatten hergestellt werden. All diesen Schwächungslinien ist gemeinsam, dass sie in eine bestimmte Richtung geknickt werden müssen, um einen sauberen Bruch zu erzielen. So muss bei US-A-5 069 195 die Schwächungslinie auf der Oberseite der Keramikleiterplatte angeordnet sein, um einen sauberen Bruch zu erzielen, während bei DE 299 19 961 U1 und DE 100 07 642 A1 die Schwächungslinie auf der Rückseite der Keramikleiterplatte angeordnet sein muss. Entsprechend muss vor dem Bestücken der Keramikleiterplatte mit den elektronischen Bauteilen klar sein, in welche Richtung am Ende dieses Herstellungsprozesses gebrochen werden soll.

Bei den geschilderten Problemen des Stands der Technik ist es die Aufgabe der vorliegenden Erfindung, eine Brechvorrichtung der geschilderten Art bereitzustellen, die einfach aufgebaut ist, mit der Hybridschaltungen unterschiedlichster Größe mit minimalem Ausschuß vereinzelt werden können und bei der die Bruchkräfte möglichst auf die Schwächungslinie begrenzt auf die Keramikleiterplatten aufgebracht werden können.

Die Aufgabe der Erfindung wird durch die kennzeichnenden Merkmale des unabhängigen Vorrichtungsanspruchs 1 und durch die kennzeichnenden Merkmale der unabhängigen Verfahrensansprüche 13 und 15 gelöst. Die abhängigen Ansprüche offenbaren weitere Vorteile der Erfindung.

Die Erfindung und Ausgestaltungen der Erfindung werden nachfolgend an Hand eines Ausführungsbeispiels erläutert. Es zeigen:
- Fig. 1: eine Seitenansicht einer erfindungsgemäßen Brechvorrichtung;
- Fig. 2: eine perspektivische Ansicht einer erfindungsgemäßen Brechvorrichtung gemäß einer alternativen Ausführungsform;
- Fig. 3: eine Seitenansicht der Brechvorrichtung von Fig. 2; und
- Fig. 4: eine Draufsicht auf die Brechvorrichtung.

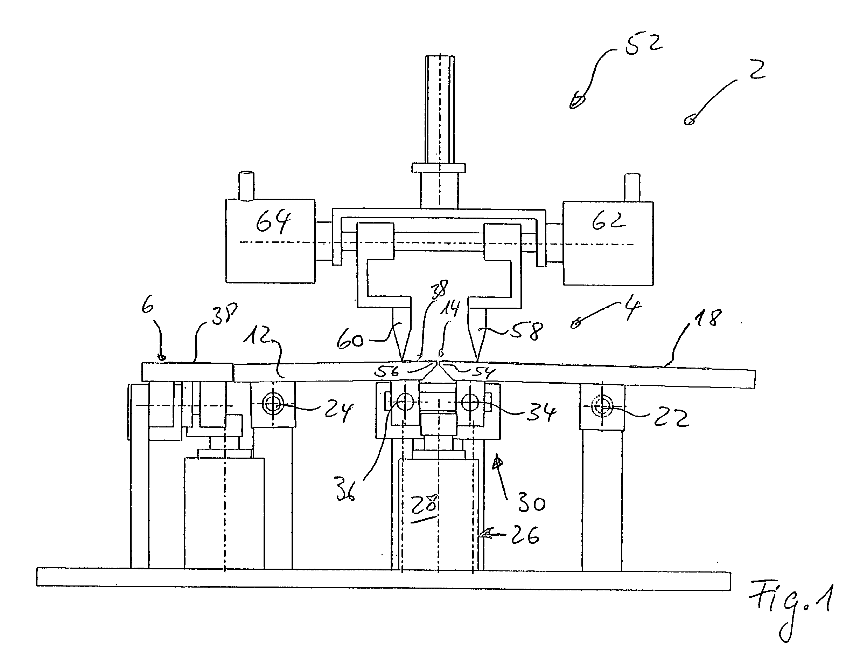

Fig. 1 zeigt eine erfindungsgemäße Brechvorrichtung 2, aufweisend eine erste Brechfalle 4. und eine zweite Brechfalle 6. Ferner erkennt man eine Niederhaltevorrichtung 52, welche an eine (nicht gezeigte) Roboterzelle angeschlossen ist. Die Niederhaltevorrichtung 52 ist vorzugsweise an diesem Manipulationsarm angeschlossen. Derartige Nianipulationsarme können innerhalb ihrer Reichweite Translationsbewegungen in sämtlichen Raumrichtungen ausführen. Sie können ferner in einem gewissen Umfang auch Rotationsbewegungen ausführen. Derartige Roboterzellen sind in der Lage, den an dem Roboterarm angeschlossenen Werkzeuge, wie beispielsweise die Niederhaltevorrichtung 52, sehr präzise zu positionieren. Die Programmierung derartiger Roboterzellen kann beispielsweise von konventionellen PCs aus über eine geeignete Schnittstelle erfolgen. Eine Roboterzelle, die sich beispielsweise für die vorliegende Anwendung besonders eignet, ist die "baumann-rolbox" mit dem integrierten Bosch Scara Roboter. Man erkennt, dass die Brechfalle 4 zwei Auflageplatten 10 und 12 aufweist, die an einer Bruchlinie 14 aneinander grenzen und eine im Wesentlichen ebene Auflagefläche in einem Ausgangszustand bilden. In der Fig. 1 ist die Brechfalle 4 in einer Bruchposition gezeigt, in der die beiden Auflageplatten 10 und 12 an ihren der Bruchlinie 14 benachbarten Bruchlinienenden 54, 56 nach oben in die Bruchposition angehoben sind. Die Auflageplatten 10 und 12 sind aus einem beliebigen Material hergestellt. Es ist günstig, wenn dieses Material relativ verschleißbeständig ist, da das Material der Keramikleiterplatten sehr abrasiv ist. Es ist bevorzugt, wenn es sich um ein antistatisches Material handelt, um eine elektrostatische Aufladung der Keramikleiterplatten in Folge der Verschiebungen der Keramikleiterplatten auf der Oberfläche der Auflageplatten 10, 12 zu vermeiden. Eine elektrostatische Aufladung würde das Risiko der Beschädigung von Bauelementen auf der Keramikleiterplatte erhöhen. Geeignete Materialien sind beispielsweise Stahl, insbesondere geschliffener Stahl, es sind jedoch auch bestimmte Kunststoffmaterialien vorstellbar.

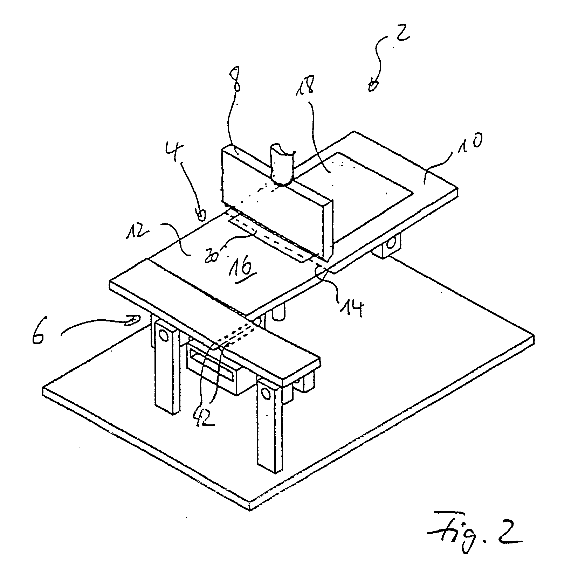

In der Fig. 1 und besser in der Fig. 2 erkennt man auch eine Keramikleiterplatte 18, die mit einer ihrer Schwächungslinien 20 in Ausrichtung mit und über der Bruchlinie 14 positioniert ist. Die Niederhaltevorrichtung 52 legt die Keramikleiterplatte 18 in dieser Position fest. Insbesondere weist die Niederhaltevorrichtung 52 zwei Eingriffsbereiche 58, 60 auf, bei denen es sich um längliche Elemente handelt, die nach unten hin spitz zulaufen. Die Eingriffsbereiche 58, 60 werden an Schwächungslinien 20 angesetzt, die parallel zu der zu brechenden Schwächungslinie sind bzw. an dem schmalen Randbereich einer Hybridschaltung angreifen. Man erkennt ferner, dass die Eingriffsbereiche 58, 60 der Niederhaltevorrichtung 52 relativ zueinander verlagerbar angeordnet sind. Insbesondere erkennt man Antriebsmotoren 62, 64, die über eine Verlagerungsschraubeneinrichtung die Position der Eingriffsbereiche 58, 60 einstellen können. Insbesondere sind die Antriebsmotoren 62, 64 derart ausgebildet, beispielsweise in der Art von Stellmotoren, dass sie jeden der Eingriffsbereiche 58, 60 an eine genau vorgegebene Position im Raum fahren können.

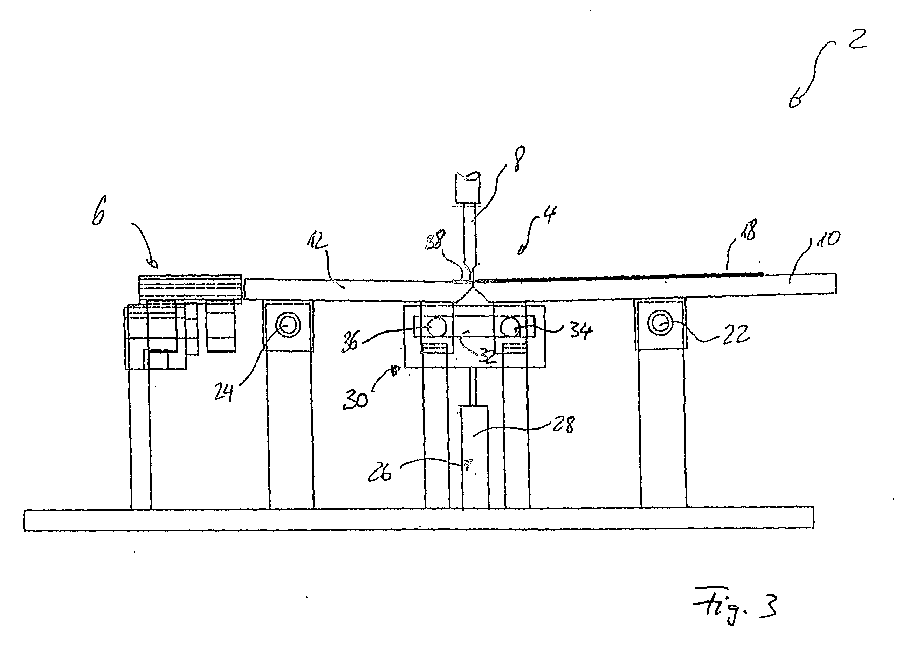

Ferner erkennt man eine Kopplungsvorrichtung, die nachfolgend mit Bezugnahme auf die Fig. 3 detaillierter beschrieben werden wird, sowie einen Antrieb 28 zum Bewegen der Auflageplatten 10 und 12.

In der in Fig. 1 gezeigten Darstellung hat der Antrieb 28 die Auflageplatten 10 und 12 und damit die Keramikleiterplatte 18 aus der Ausgangsposition nach oben in die Bruchposition angehoben. Dabei wurde die Schwächungslinie 20 an der Bruchlinie 14 gebrochen. Die Bewegung der Auflageplatten 10 und 12 ist gegen eine elastisch nachgiebige Kraft der Niederhaltevorrichtung 52 erfolgt. Es ist theoretisch auch möglich, die Auflageplatten 10 und 12 so anzuordnen, dass diese sich bei der Bewegung um den von den Eingriffsbereichen 58 und 60 gebildeten Drehpunkt um die von den 58 und 60 gebildeten Drehpunkte drehen können, so dass eine elastische Nachgiebigkeit der Niederhaltevorrichtung 52 nicht erforderlich ist.

In den Figuren 2 und 3 ist eine alternative Ausführungsform der Brechvorrichtung 2 gezeigt. Einander korrespondierende Elemente der einzelnen Brechvorrichtungen 2 sind mit gleichen Bezugszeichen angegeben. Grundsätzlich gilt, dass die mit Bezug auf eine der Ausführungsformen beschriebenen Merkmale entsprechend bei den anderen Ausführungsformen vorgesehen sein können. Insbesondere kann die Niederhaltevorrichtung 52 bei dieser Ausführungsform im Wesentlichen so ausgebildet sein wie bei der Ausführungsform gemäß Fig. 1. Das bei dieser Ausführungsform gezeigte Brechschwert 8 entspricht der Niederhaltevorrichtung 52, bzw. ist Bestandteil davon. Insbesondere kann das Brechschwert 8 einen der Eingriffbereiche 58, 60 der Niederhaltevorrichtung bilden. Der zweite Eingriffbereich der Niederhaltevorrichtung 52 ist dann vorzugsweise zur Seite bewegt, so dass er die Funktion des Brechschwerts 8 bzw. des anderen Eingriffsbereichs nicht beeinträchtigt. Alternativ kann der zweite Eingriffsbereich auch entfernt sein. Das Brechschwert 8 kann aber auch alleine die Niederhaltevorrichtung 52, 8 realisieren.

Man erkennt in der Fig. 2, dass das Brechschwert 8 in Ausrichtung mit und über der Bruchlinie 14 positioniert ist.

Fährt das Brechschwert 8 nach unten, so trifft es auf die Schwächungslinie 20 der Keramikleiterplatte 18 und drückt diese gegen die Bruchlinie 14 der Brechfalle 4 nach unten in die Bruchposition.

In Fig. 1 und 3 ist die Bruchposition der Brechfalle 4 gezeigt, in der die Auflageplatten 10 und 12 keine im Wesentlichen ebene Auflagefläche 16 bilden, sondern mit einem Winkel zueinander angeordnet sind.

Die erste und die zweite Brechfalle 4 und 6 sind im Wesentlichen identisch ausgebildet. Die zweite Brechfalle 6 bei der vorliegenden Ausführungsform ist mit einem Winkel von 90° relativ zu der ersten Brechfalle angeordnet, d.h. die Bruchlinien 14 der beiden Brechfallen schließen einen Winkel von 90° ein. Dieser Winkel ist bestimmt durch den Winkel der Schwächungslinien 20 auf der Keramikleiterplatte 18, der typischerweise 90° beträgt. Es sind für spezielle Anwendungen theoretisch auch andere Winkel vorstellbar. Dann kann es günstig sein, die zweite Brechfalle in einem korrespondierenden Winkel zur ersten Brechfalle anzuordnen. Da an der zweiten Brechfalle 6 nur noch Streifen oder Reihen von Hybridschaltungen der Keramikleiterplatte 18 gebrochen werden müssen, ist diese bei der gezeigten Ausführungsform deutlich schmaler als die erste Brechfalle 4. Es kann jedoch auch Situationen geben, wo es günstig ist, die zweite Brechfalle 6 in etwa genauso breit oder sogar breiter auszubilden als die erste Brechfalle 4.

Die Fig. 3 zeigt eine Seitenansicht der Brechvorrichtung 2 gemäß Fig. 2. Man erkennt wieder das Brechschwert 8, die erste Brechfalle 4 und die zweite Brechfalle 6. Man erkennt ferner die Auflageplatten 10 und 12 der ersten Brechfalle 4. Man erkennt, dass die Auflageplatten 10 und 12 bei 22 und 24 drehbar gelagert sind. Die erste und die zweite Auflageplatte können sich um die Drehpunkte 22 und 24. relativ zueinander bewegen. Man erkennt insbesondere, dass in der Fig. 3 die erste und die zweite Auflageplatte 10 und 12 an der Bruchlinie 14 nach unten verlagert sind. Insbesondere sind sie in der Fig. 3 in die Bruchposition verlagert, in der die beiden Auflageplatten 10 und 12 keine ebene Auflagefläche bilden, sondern mit einem Winkel zueinander angeordnet sind. Zwischen der Ausgangsposition und der Bruchposition reicht ein relativ kurzer Weg, da die Brechkraft von dem Brechschwert 8 unmittelbar auf die Schwächungslinie 20 aufgebracht wird und entsprechend der Bruch schon bei einer relativ geringen Winkelveränderung der Auflageplatten 10 und 12 erfolgt. Aus dem Vergleich der Figuren 2 und 3 erkennt man ferner, dass das Brechschwert 8 nach unten auf die Bruchlinie 14 in der Ausgangsposition zu bewegt werden kann und über die Bruchlinie 14 in der Ausgangsposition nach unten weiter bewegt werden kann. Bei dieser Weiterbewegung drückt das Brechschwert 8 die Keramikleiterplatte 18 im Bereich der Schwächungslinie 20 gegen die freien Enden der Auflageplatten 10 und 12 und drückt diese freien Enden nach unten. Damit diese Bewegung der Auflageplatten 10 und 12 kontrolliert erfolgt, ist eine Einrichtung 26 vorgesehen, die eine gewisse Gegenkraft bereitstellt, so dass die Bewegung nach unten nachgiebig gegen eine Gegenkraft erfolgt. Die Einrichtung 26 kann nach verschiedensten Prinzipien arbeiten. Es ist günstig, wenn die Einrichtung 26 so ausgebildet ist, dass sie die möglicherweise gespeicherte Energie nach dem Bruch nicht schlagartig frei gibt. Vielmehr sollen die Auflageplatten 10, 12 nach dem Bruch entweder in der Bruchposition verbleiben, bis sie aktiv wieder bewegt werden, oder sie sollen sich nur allmählich wieder in die Ausgangsposition zurück bewegen. So können beispielsweise Federn, die mit Dämpfungselementen gekoppelt sind, oder pneumatische Einrichtungen verwendet werden. Bevorzugt ist jedoch, einen Antrieb 28 beispielsweise in der Art eine Servo-Linearmotors oder eines Stell-Linearmotors bereitzustellen, der einerseits gegen eine vorgegebene Gegenkraft nach unten bewegt werden kann und andererseits gleichzeitig den Antrieb der Auflageplatten 10, 12 bewerkstelligen kann. Ein weiterer Vorteil eines derartigen Antriebsmotors ist, dass die genaue Position der Auflageplatten 10, 12 immer über den Servo-Linearmotor 28 bestimmt werden kann und umgekehrt eine genaue Positionierung im Raum möglich ist.

In diesem Zusammenhang sei darauf hingewiesen, dass der Bewegungsweg der Brechfalle 4 und 6 bis in die Bruchposition bei der Brechvorrichtung 2 gemäß der vorliegenden Erfindung sehr unkritisch ist, was im Verhältnis zum Stand der Technik von entscheidendem Vorteil ist, da keine aufwändigen Einstellarbeiten zur Inbetriebnahme erforderlich sind.

In der Fig. 3 erkennt man ferner eine Kopplungsvorrichtung 30, mittels derer die Auflageplatten 10, 12 der Brechfalle 4 verbunden sind, um so die Bewegungen der Auflageplatten 10, 12 zu synchronisieren. Die Kopplungsvorrichtung weist insbesondere eine Kulissenführung 32 auf, in der mit den Auflageplatten 10, 12 verbundene Zapfen 34, 36 geführt sind. Die Kopplungsvorrichtung 30 selbst ist derart angeschlossen, dass sie Bewegungsfreiheitsgrade nur nach oben und unten hat, nicht jedoch verkippt oder verdreht werden kann. Damit ist eine Synchronisierung der Bewegung der Auflageplatten 10, 12 sichergestellt. Die Kopplungseinrichtung 30 kann auch mechanisch auf andere Weise realisiert werden, beispielsweise mittels zweier Hebelverbindungen, die von dem Antrieb 28 zu der Auflageplatte 10 bzw. zu der Auflageplatte 12 gehen und jeweils beidseitig gelenkig angeschlossen sind. Es ist auch möglich, die Auflageplatten 10 und 12 jeweils mit einem eigenen Antriebsmotor auszubilden und diese elektronisch so miteinander zu koppeln, dass nur im Wesentlichen synchrone Bewegungen der Auflageplatten 10, 12 möglich sind.

In der Fig. 3 erkennt man auch ein Bruchstück 38 der Keramikleiterplatte 18, welches bereits abgebrochen wurde. Nach dem Anheben des Brechschwerts 8 aus der in Fig. 2 gezeigten Position und nach dem Zurückbewegen der Auflageplatten 10, 12 in die Ausgangsposition ist zwischen der Keramikleiterplatte 18 und dem Bruchstück 38 nur ein extrem schmaler Spalt, der nicht ausreicht, um das Bruchstück 38 in Richtung nach links in der Darstellung der Fig. 3 zu bewegen. Man könnte sich überlegen, einen Greifer vorzusehen, mit dem das Bruchstück 38 an seinen Längsenden ergriffen wird und weiter transportiert wird. Das ist jedoch nachteilig, da es vereinzelt zu einem Brechen quer zur Längsrichtung des Bruchstücks 38 kommen kann. Ein derartig zusätzlich gebrochenes Bruchstück 38 lässt sich nicht problemlos weiter transportieren und würde bei einer derartigen Auslegung eines Transportelements den Betrieb der Brechvorrichtung erheblich stören. Bei der erfinderischen Brechvorrichtung 2 ist es deshalb bevorzugt, den Antrieb 28 für die Auflageplatten 10, 12 so auszulegen, dass er die freien Enden der Auflageplatten 10, 12 derart über die Ausgangsposition nach oben anheben kann, dass ein Spalt zwischen den freien Enden der Auflageplatten 10, 12 und entsprechend auch zwischen dem Bruchstück 38 und der Keramikleiterplatte 18 entsteht. In diesen Spalt kann ein Transportelement, beispielsweise einer der Eingriffsbereiche 58, 60 oder das Brechschwert 8 oder ein anderes geeignetes Transportelement eintauchen und das Bruchstück 38 von seiner Längsseite her nach links in der Darstellung der Fig. 3 verschieben. Von dort kann das Bruchstück 38 zur weiteren Bearbeitung übernommen werden.

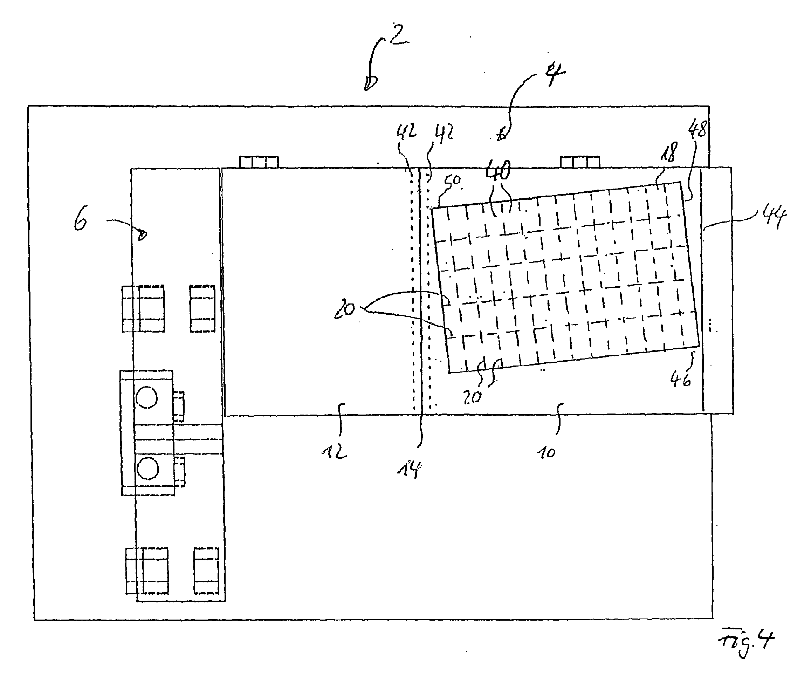

Fig. 4 zeigt die Draufsicht auf eine Brechvorrichtung 2 gemäß der vorliegenden Erfindung. Man erkennt insbesondere wieder die mit einem 90° Winkel zueinander angeordnete erste und zweite Brechfalle 4, 6. Man erkennt die Auflageplatten 10, 12 der ersten Brechfalle, und man erkennt die Bruchlinie 14. Ferner erkennt man sehr deutlich eine Keramikleiterplatte 18, die in dieser Form auch als "Nutzen" bezeichnet wird. Ein Nutzen weist typischerweise mehrere Reihen und Spalten von einzelnen Hybridschaltungen 40 auf, die jeweils durch Schwächungslinien 20 voneinander getrennt sind. In vielen Fällen ist zusätzlich ein Stützrand um die Reihen und Spalten von Hybridschaltungen 40 angeordnet, der für die vorangehenden Bearbeitungsschritte eine zusätzliche Festigkeit dem Nutzen oder der Keramikleiterplatte 18 gibt. In der Fig. 4 ist ein derartiger Stützrand nicht gezeigt. Typischerweise ist der Stützrand auch mit Schwächungslinien 20 angeordnet. Der Stützrand kann auch mit einer Brechvorrichtung 2 gemäß der vorliegenden Erfindung abgebrochen werden. Es sei darauf hingewiesen, dass die Integration bei den Hybridschaltungen 40 inzwischen so weit fortgeschritten ist, dass die einzelnen Bauteile zum Teil bereits 0,4 bis 0,6 mm von der Bruchkante entfernt angeordnet sind. Das heißt, die Niederhaltevorrichtung bzw. das Brechschwert 52 bzw. 8 muss derart ausgebildet sein und muss derart genau bewegt werden, dass es zuverlässig in diesem sehr schmalen Bereich zwischen zwei Reihen von Hybridschaltungen 40 eintauchen kann und dort die Keramikleiterplatte 18 brechen kann, bzw. dort die Keramikleiterplatte festlegen kann. Entsprechend genau muss auch die Positionierung der Keramikleiterplatte 18 erfolgen, d.h. entsprechend genau muss die Position der Schwächungslinie 20 nach dem Positionieren der Keramikleiterplatte 18 bestimmbar sein. Es ist eine Bremseinrichtung 42 vorgesehen, die bei dem vorliegenden Ausführungsbeispiel in der Form von einer Reihe von Saugöffnungen im Bereich der freien Enden der Auflageplatten 10, 12 in der Nähe der Bruchlinie 14 vorgesehen sind. Durch diese Saugöffnungen wird im Wesentlichen kontinuierlich ein gewisses Luftvolumen gesaugt, so dass die Keramikleiterplatte 18, sobald sie in den Bereich der Bremseinrichtung 42 gelangt, mit einer gewissen Saugkraft gegen die Auflageplatten 10, 12 gesaugt wird und somit gebremst wird. Das ist zum einen wichtig, um ggf. den Impuls der Keramikleiterplatte 18 abzubremsen, der ihr durch die Bewegung beim Positionieren vermittelt wird. Zum anderen wird damit nach dem Positionieren die Position der Keramikleiterplatte 18 sichergestellt, beispielsweise gegen Vibrationen und Stöße, die bei dem Betrieb der Brechvorrichtung 2 auftreten oder die auf andere Weise auf das System aufgebracht werden. Die Saugkraft der Bremseinrichtung 42 wird vorzugsweise so eingestellt, dass kontinuierlich eine gewisse Menge an Luft durch die Saugöffnungen gesaugt wird. Alternativ ist es auch möglich, beispielsweise nach dem Brechen die Saugeinrichtung abzustellen, um ein Bruchstück 38 bzw. die Keramikleiterplatte 18 weiter zu bewegen.

Das Positionieren eines Nutzen bzw. einer Keramikleiterplatte 18 auf der Brechfalle 4 und entsprechend auch auf der Brechfalle 6 erfolgt folgendermaßen. Der Nutzen 18 wird von einer vorangehenden Bearbeitungsstation in konventioneller Weise auf die Brechfalle 4 verbracht. Die in der Fig. 4 gezeigte verdrehte Position des Nutzens 18 ist schon eine sehr extreme Position, zu der es betriebsmäßig praktisch nicht kommen wird. Der Nutzen 18 liegt dann auf der Auflageplatte 10 der Brechfalle 4 oder auf einer dieser vorgeschalteten Positionierfläche. Eine Positionierelement 44, es im Eingriffsbereich mit dem Nutzen 18 ein im Wesentlichen längliches Element ist, wird im Wesentlichen rechtwinklig zu seiner Längsrichtung auf den Nutzen 18 zu bewegt und berührt diesen zuerst an der Ecke 46. In Folge der weiteren Bewegung bringt es eine Drehmomentkraft auf die Ecke 46 auf, die tendenziell bestrebt ist, den Nutzen 18 so auszurichten, dass dieser über die gesamte Endkante 48 in Anlage mit dem Positionierelement 44 kommt. Sobald der Bereich der vorderen Ecke 50 in den Bereich der Bremseinrichtung 42 gelangt, wird dieser Bereich zusätzlich abgebremst, wodurch das Drehmoment erhöht wird und die Ausrichtung des Nutzens 18 zusätzlich unterstützt wird. Auf diese Weise ist sichergestellt, dass der Nutzen 18 korrekt positioniert ist, sobald die erste Schwächungslinie 20 über der Bruchlinie 14 positioniert ist. Die Bremseinrichtung 42 hält den Nutzen 18 dann in Position für den eigentlichen Brechvorgang. Es kann günstig sein, das Brechschwert 8 als Positionierelement 44 zu benutzen. Es kann auch günstig sein, eine Bremseinrichtung 42 weiter weg von der Bruchlinie 14 zu positionieren, insbesondere dann, wenn diese Bremseinrichtung 42 an einer derartigen Position das Positionieren unterstützen kann.

Es können mehrere Bremseinrichtungen 42 über die Auflageplatten 10, 12 verteilt vorgesehen sein. Ggf. können auch an einer vorgeschalteten Positionierfläche eine oder mehrere Bremseinrichtungen 42 vorgesehen sein.

Ein abgetrennter Streifen bzw. ein Bruchstück 38 mit mehreren Hybridschaltungen wird von einem Transportelement bzw. von dem Brechschwert 8 nach links auf die zweite Brechfalle 6 transportiert und dort in im Wesentlichen gleicher Weise positioniert und anschließend gebrochen. Die vereinzelten Hybridschaltungen werden dann weiter verarbeitet oder verpackt. An Stelle der zweiten Brechfalle 6 oder zusätzlich zu der zweiten Brechfalle 6 kann eine Drehvorrichtung vorgesehen sein. Dabei kann es sich entweder um eine Fläche handeln, die beispielsweise an die ebene Fläche 16 der ersten Brechfalle 4 in der Ausgangsposition anschließt und die um einen beliebigen Winkel, vorzugsweise 90° um die Senkrechte zu dieser Fläche gedreht werden kann. Damit können an einer Brechfalle vier Schwächungslinien 20 gebrochen werden, die nicht parallel zueinander sind, und es können insbesondere mit einer Brechfalle 4 die rechtwinklig verlaufenden Schwächungslinien 20 bei einem Nutzen 18, wie in Fig. 4 gezeigt, gebrochen werden.

Es sei ferner darauf hingewiesen, dass es sich bei den Darstellungen den Figuren 1 einerseits und 2 bis 4 andererseits nicht zwangsläufig um verschiedene Ausführungsformen handeln muss. Es kann auch eine einzige Ausführungsform der Brechvorrichtung 2 so ausgebildet sein, dass sie eine Keramikleiterplatte 18 sowohl durch eine Bewegung in eine Brechposition nach oben als auch durch eine Bewegung in eine Brechposition nach unten brechen kann, insbesondere je nachdem, wie die Schwächungslinie an der Keramikleiterplatte 18 angeordnet ist und wie die Bruchrichtung der Keramikleiterplatte ist. Es sei ferner darauf hingewiesen, dass als Positioniereinrichtung auch eine dünne elastische, beispielsweise gummiartige Positioniermatte in der Art eines Transportbands vorgesehen sein kann, mittels derer die Keramikleiterplatte 18 relativ zu der Brechfalle und der Niederhaltevorrichtung 52, 8 verlagerbar ist. Das ist insbesondere dann bevorzugt, wenn aus verschiedenen Gründen ein Verschieben der Keramikleiterplatte 18 auf einer Unterlage nach Möglichkeit vermieden sein soll. Es kann auch günstig sein, statt die Positioniermatte relativ zur Brechfalle und der Niederhaltevorrichtung 52, 8 zu verlagern, Letztere beide relativ zu der im Raum festgelegten Positioniermatte zu verlagern, d.h. Brechfalle 4 und Niederhaltevorrichtung 52, 8 werden relativ zur Positioniermatte und der Keramikleiterplatte 18 von Schwächungslinie zu Schwächungslinie verlagert.

## Patentansprüche

1. Brechvorrichtung (2) für das Vereinzeln von Keramikleiterplatten (18) entlang von Schwächungslinien (20) auf einer Keramikleiterplatte (18), aufweisend eine Brechfalle (4, 6) mit relativ zueinander verlagerbaren Auflageplatten (10, 12), die aus einer Ausgangsposition, in der die Auflageplatten (10, 12) an einer Bruchlinie (14) aneinander grenzen und eine im Wesentlichen ebene Auflagefläche (16) bilden, in eine Bruchposition verlagert werden können, in der die Auflageplatten (10, 12) mit einem Winkel zueinander angeordnet sind, und eine Niederhaltevorrichtung (52, 8), die derart ausgebildet ist, dass sie für einen Bruchvorgang die Keramikleiterplatte (18) gegen die Auflageplatten (10. 12) positioniert, wobei die Brechfalle (4, 6) zwei Auflageplatten (10, 12) aufweist, die an einer Bruchlinie (14) aneinander grenzen, wobei die Auflageplatten (10, 12) der Bruchlinie (14) benachbarte Bruchlinienenden (54, 56) aufweisen, wobei die Niederhaltevorrichtung (52, 8) einen länglichen und quer zur Längsrichtung schmalen Eingriffsbereich (58, 60) aufweist,
wobei die Brechvorrichtung (2) ein Positionierelement (44) aufweist, das derart ausgebildet ist, dass es die Schwächungslinien (20) nacheinander in Ausrichtung mit und über der Bruchlinie (14) positionieren kann, **dadurch gekennzeichnet, dass** mindestens ein Bruchlinienende (54, 56) der Auflageplatten (10, 12) der Brechfalle (4, 6) nach oben verlagert werden kann, dass die Auflageplatten (10, 12) derart angeordnet sind, dass ein Bruchstück der Keramikplatte zum Wegschieben exponiert ist, und wobei die Brechvorrichtung ferner ein Transportelement aufweist, das derart ausgebildet ist, dass es betriebsmäßig dem Rand des exponierten Bruchstücks (38) der Keramikleiterplatte (18) benachbart angeordnet werden kann und dann verlagert werden kann, um das Bruchstück (38) weg zu schieben.

2. Brechvorrichtung (2) nach Anspruch 1, **dadurch gekennzeichnet, dass** das Positionierelement (44) das Transportelement ist.

3. Brechvorrichtung (2) nach Anspruch 1 oder 2, **dadurch gekennzeichnet, dass** die Brechfalle (4, 6) derart ausgebildet ist, dass die Bruchlinienenden (54, 56) wahlweise in eine Bruchposition nach oben oder in eine Bruchposition nach unten verlagert werden können.

4. Brechvorrichtung (2) nach einem der Ansprüche 1 bis 3, **dadurch gekennzeichnet, dass** der Eingriffsbereich (58, 60) der Niederhaltevorrichtung (52, 8) im Wesentlichen parallel zu der Bruchlinie (14) angeordnet ist.

5. Brechvorrichtung (2) nach einem der Ansprüche 1 bis 4, **dadurch gekennzeichnet, dass** die Niederhaltevorrichtung (52, 8) zwei parallele Eingriffsbereiche (58, 60) aufweist.

6. Brechvorrichtung (2) nach Anspruch 5, **dadurch gekennzeichnet, dass** die Eingriffsbereiche (58, 60) relativ zueinander verlagerbar sind.

7. Brechvorrichtung (2) nach einem der Ansprüche 1 bis 5, **dadurch gekennzeichnet, dass** die Niederhaltevorrichtung (52, 8) ein Brechschwert (8) aufweist, welches derart an der Brechvorrichtung (2) angeschlossen ist, dass es über der Bruchlinie (14) positioniert und in Richtung auf die Bruchlinie (14) zu und darüber hinaus bewegt werden kann, wobei die Auflageplatten (10, 12) derart nachgiebig angeordnet sind, dass sich die Bruchiinienenden (54, 56) der Auflageplatten (10, 12) im Verlauf der Bewegung des Brechschwerts (8) nach unten über die Bruchlinie (14) hinaus nach unten in die Bruchposition verlagern.

8. Brechvorrichtung (2) nach einem der Ansprüche 1 bis 7, ferner aufweisend eine Kopplungseinrichtung (30), die derart mit den Auflageplatten (10, 12) der Brechfalle (4, 6) verbunden ist, dass sie die Bewegungen der Auflageplatten (10, 12) synchronisiert.

9. Brechvorrichtung (2) nach einem der Ansprüche 1 bis 8 **dadurch gekennzeichnet, dass** eine Steuerung vorgesehen ist, die die Bewegungen der Brechfalle (46) mit den Bewegungen der weiteren Elemente (52, 8, 44) der Brechvorrichtung (2) koordiniert, und eine Eingabeschnittstelle aufweist, über die die Maße der zu vereinzelnden Keramikleiterplatten (18) und die Position und/oder die Abstände der darauf angeordneten Schwächungslinien (20) und/oder die Bruchrichtung eingegeben werden können.

10. Brechvorrichtung (2) nach einem der Ansprüche 1 bis 8, **dadurch gekennzeichnet, dass** eine Bremseinrichtung (42) für die Keramikleiterplatte (18) vorgesehen ist.

11. Brechvorrichtung (2) nach einem der Ansprüche 1 bis 10, **dadurch gekennzeichnet, dass** eine Drehvorrichtung vorgesehen ist, mittels derer betriebsmäßig die zu bearbeitende Keramikleiterplatte (18) und/oder deren Bruchstücke (38) um eine Achse gedreht werden können, die senkrecht zu den Auflageplatten (10, 12) ist.

12. Brechvorrichtung (2) nach einem der Ansprüche 1 bis 11, **dadurch gekennzeichnet, dass** eine zweite Brechfalle (6) vorgesehen ist, die derart in der Brechvorrichtung (2) angeordnet ist, dass ihre Bruchlinie (14), in der Ebene der Auflageplatten (10, 12) betrachtet, mit einem Winkel relativ zu der Bruchlinie der ersten Brechfalle (4) angeordnet ist.

13. Verfahren zum Vereinzeln von Keramikleiterplatten (18) entlang von Schwächungslinien (20) auf einer Keramikleiterplatte (18), aufweisend die folgenden Schritte:
(a) Bereitstellen einer Brechfalle (4, 6) mit zwei relativ zueinander verlagerbaren Auflageplatten (10, 12), die aus einer Ausgangsposition, in der die Auflageplatten (10, 12) an einer Bruchlinie (14) aneinander grenzen und eine im Wesentlichen ebene Auflagefläche (16) bilden, in eine Bruchposition verlagert werden können, in der die beiden Auflageplatten (10, 12) mit einem Winkel zueinander angeordnet sind,
(b) Positionieren einer Keramikleiterplatte (18) derart auf den Auflageplatten (10, 12) in der Ausgangsposition, dass eine Schwächungslinie (20), entlang derer gebrochen werden soll, im Wesentlichen über der Bruchlinie (14) liegt;
(c) Absenken einer Niederhaltevorrichtung (52), die zwei längliche, Eingriffsbereiche (58, 60) aufweist, derart auf die Keramikleiterplatte (18), dass diese im Bereich zweier Schwächungslinien (20), die der Schwächungslinie (20), entlang derer gebrochen werden soll, benachbart sind, eine Niederhaltekraft auf die Keramikleiterplatte (18) ausüben;
(d) Brechen der Keramikleiterplatte (18) durch Anheben der Bruchlinienenden (54, 56) der Auflageplatten (10, 12) der Brechfalle (4, 6) nach oben in die Bruchposition;
(e) Anheben der Niederhaltevorrichtung (52) und Freigeben der Bruchstücke (38) der Keramikleiterplatte (18);
**gekennzeichnet durch** die folgenden Schritte:
(f) Greifen in den Spalt zwischen den Bruchstücken (38, 18) und Wegschieben eines der Bruchstücke;
(g) Zurückverlagern der Auflageplatten (10, 12) in die Ausgangsposition;
(h) Positionieren der Keramikleiterplatte (18) derart auf den Auflageplatten (10, 12), dass eine weitere Schwächungslinie (20), entlang derer gebrochen werden soll, im Wesentlichen über der Bruchlinie (14) liegt; und
(i) Wiederholen der Schritte (c) bis (h) bis die Keramikleiterplatte (18) entlang der Schwächungslinien (20), entlang derer gebrochen werden soll, gebrochen wurde.

14. Verfahren nach Anspruch 13, ferner aufweisend den Schritt des Verlagerns der Bruchlinienenden (54, 56) der Auflageplatten (10, 12) nach oben in eine Abgreifposition, um den Spalt zwischen den Bruchstücken zu vergrößern.

15. Verfahren zum Vereinzeln von Keramikleiterplatten (18) entlang von Schwächungslinien (20) auf einer Keramikleiterplatte (18), aufweisend die folgenden Schritte:
a) Bereitstellen einer Brechfalle (4, 6) mit zwei relativ zueinander verlagerbaren Auflageplatten (10, 12), die aus einer Ausgangsposition, in der die Auflageplatten (10, 12) an einer Bruchlinie (14) an einander grenzen und eine im Wesentlichen ebene Fläche (16) bilden, in eine Bruchposition verlagert werden können, in der die beiden Auflageplatten (10, 12) mit einem Winkel zueinander angeordnet sind;
b) Positionieren einer Keramikleiterplatte (18) derart auf den Auflageplatten (10, 12) in der Ausgangsposition, dass eine Schwächungslinie (20), entlang derer gebrochen werden soll, im Wesentlichen über der Bruchlinie (14) liegt;
(c) Brechen der Keramikleiterplatte (18) durch Absenken eines Brechschwerts (52, 8), das im Wesentlichen mit der Schwächungslinie (20) ausgerichtet ist, gegen die Schwächungslinie (20) und gegen eine vorgegebene Kraft der Auflageplatten (10, 12) und dabei nach unten Verlagern der Auflageplatten (10, 12) in die Bruchposition;
(d) Anheben des Brechschwerts (52, 8);
**gekennzeichnet durch** die folgenden Schritte:
(e) Verlagern von mindestens einem der der Bruchlinien (14) benachbarten Bruchlinienenden (54, 56) der Auflageplatten (10, 12) nach oben, so dass die Auflageplatten (10, 12) derart angeordnet sind, dass ein Bruchstück der Keramikplatte zum Wegschieben exponiert ist;
(f) Wegschieben des exponierten Bruchstücks (38);
(g) Zurückverlagern der Auflageplatten (10, 12) in die Ausgangsposition;
(h) Positionieren der Keramikleiterplatte (18) derart auf den Auflageplatten (10, 12), dass eine weitere Schwächungslinie (20), entlang derer gebrochen werden soll, im Wesentlichen über der Bruchlinie (14) liegt; und
(i) Wiederholen der Schritte (c) bis (h) bis die Keramikleiterplatte entlang der Schwächungslinien (20), entlang derer gebrochen werden soll, gebrochen wurde.

16. Verfahren nach Anspruch 15, wobei der Schritt (e) das Verlagern der Bruchlinienenden (54, 56) der Auflageplatten (10, 12) nach oben in eine Abgreifposition aufweist, um den Spalt zwischen den Bruchstücken (38, 18) einer Keramikleiterplatte (18) zu vergrößern.

17. Verfahren nach Anspruch 16, ferner aufweisend das Greifen in den Spalt zwischen den Bruchstücken (38, 18) und Wegschieben eines der Bruchstücke (38).

18. Verfahren nach einem der Ansprüche 13 bis 17, wobei die Bewegungen der Auflageplatten (10, 12) synchron ausgeführt werden.

19. Verfahren nach einem der Ansprüche 13 bis 18, aufweisend den Schritt des Abbremsens der Keramikleiterplatte (18) nach dem Positionieren.

## Claims

1. Breaking device (2) for singularizing ceramic conductor plates (18) along weakening lines (20) on a ceramic conductor plate (18), comprising a breaking trap (4, 6) with support plates (10, 12) displaceable relatively to one another, which can be displaced from an initial position in which the support plates (10, 12) adjoin along a breaking line (14) and form an essentially flat support surface (16) to a breaking position in which the support plates (10, 12) are arranged in an angle toward one another, and a pinning device (52, 8) which is formed such that it positions the ceramic conductor plate (18) against the support plates (10, 12) for a breaking operation, wherein the breaking trap (4, 6) comprises two support plates (10, 12) adjoining along a breaking line (14), wherein the support plates (10, 12) comprise breaking line ends (54, 56) adjacent to the breaking line (14), wherein the pinning device (52, 8) comprises an oblong engagement section (58, 60) which is narrow transverse to its longitudinal direction,
wherein the breaking device (2) comprises a positioning element (44) which is formed such that it can position the weakening lines (20) consecutively in alignment with and above the breaking line (14), **characterized in that** at least one breaking line end (54, 56) of the support plates (10, 12) of the breaking trap (4, 6) can be upwardly displaced such that the support plates (10, 12) are arranged such that a fragment of the ceramic plate is exposed for sliding aside and wherein the breaking device further comprises a transport element which is formed such that it can be operationally arranged adjoining the edge of the exposed fragment (38) of the ceramic conductor plate (18) and can then be displaced to slide aside the fragment (38).

2. Breaking device (2) according to claim 1, **characterized in that** the positioning element (44) is the transport element.

3. Breaking device (2) according to claim 1 or 2, **characterized in that** the breaking trap (4, 6) is formed such that the breaking line ends (54, 56) can selectively be displaced upwardly into a breaking position or downwardly into a breaking position.

4. Breaking device (2) according to one of claims 1 to 3, **characterized in that** the engagement section (58, 60) of the pinning device (52, 8) is arranged essentially in parallel to the breaking line (14).

5. Breaking device (2) according to one of claims 1 to 4, **characterized in that** the pinning device (52, 8) comprises two parallel engagement sections (58, 60).

6. Breaking device (2) according to claim 5, **characterized in that** the engagement sections (58, 60) are displaceable relative to one another.

7. Breaking device (2) according to one of claims 1 to 5, **characterized in that** the pinning device (52, 8) comprises a breaking knife (8) which is connected to the breaking device (2) such that it can be positioned above a breaking line (14) and be moved in direction of and beyond the breaking line (14), wherein the support plates (10, 12) are arranged resiliently such that the breaking line ends (54, 56) of the support plates (10, 12) are displaced downwardly beyond the breaking line (14) into the breaking position during the downward movement of the breaking knife (8).

8. Breaking device (2) according to one of claims 1 to 7, further comprising a coupling device (30) which is associated with the support plates (10, 12) of the breaking trap (4, 6) such that it synchronizes the movements of the support plates.

9. Breaking device (2) according to one of claims 1 to 8, **characterized in that** a control is provided which coordinates the movements of the breaking trap (4, 6) with the movements of further elements (52, 8, 44) of the breaking device (2) and comprises an input interface through which the measurements of the ceramic conductor plates (18) to be singularized and the position and/or the distances of the weakening lines (20) arranged thereon and/or the breaking direction can be input.

10. Breaking device (2) according to one of claims 1 to 8, **characterized in that** a retardation means (42) for the ceramic conductor plate (18) is provided.

11. Breaking device (2) according to one of claims 1 to 10, **characterized in that** a turning device is provided by means of which the ceramic conductor plate (18) to be processed and/or its fragments (38) can be rotated operationally about an axis which is perpendicular to the support plates (10, 12).

12. Breaking device (2) according to one of claims 1 to 11, **characterized in that** a second breaking trap (6) is provided which is arranged in the breaking device (2) such that its breaking line (14) viewed in the plane of the support plates (10, 12) is arranged with an angle relative to the breaking line of the first breaking trap (4).

13. Method for singularizing ceramic conductor plates (18) along weakening lines (20) of the ceramic conductor plate (18), comprising the following steps:
(a) providing a breaking trap (4, 6) having two support plates (10, 12) displaceable relative to one another which can be displaced from an initial position in which the support plates (10, 12) adjoin along a breaking line (14) and form an essentially flat support surface (16) to a breaking position in which both support plates (10, 12) are arranged with an angle toward one another;
(b) positioning a ceramic conductor plate (18) on the support plates (10, 12) in the initial position such that a weakening line (20) along which breaking should occur is essentially above the breaking line (14);
(c) lowering a pinning device (52) comprising two oblong engagement sections (58, 60) on the ceramic conductor plate (18) such that they transmit a pinning force onto the ceramic conductor plate (18) in the zone of two weakening lines (20) adjacent to the weakening line (20), along which breaking should occur;
(d) breaking the ceramic conductor plate (18) by raising the breaking line ends (54, 56) of the support plates (10, 12) of the breaking trap (4, 6) upwardly into the breaking position;
(e) raising the pinning device (52) and releasing the fragments (38) of the ceramic conductor plate (18);
**characterized by** the following steps:
(f) gripping into the gap between the fragments (38, 18) and sliding aside one of the fragments;
(g) returning the support plates (10, 12) in the initial position;
(h) positioning the ceramic conductor plate (18) on the support plates (10, 12) such that a further weakening line (20), along which breaking should occur, is positioned essentially above the breaking line (14); and
(i) repeating the steps (c) to (h) until the ceramic conductor plate (18) is broken along the weakening line (20), along which breaking should occur.

14. Method according to claim 13, further comprising the step of displacing the breaking line ends (54, 56) of the support plates (10, 12) upwardly into a gripping position to enlarge the gap between the fragments.

15. Method for singularizing ceramic conductor plates (18) along weakening lines (20) on a ceramic conductor plate (18) comprising the following steps:
(a) providing a breaking trap (4, 6) with two support plates (10, 12) displaceable relative to one another, which can be displaced from an initial position in which the support plates (10, 12) adjoin along a breaking line (14) and form an essentially flat surface (16) into a breaking position in which the two support plates (10, 12) are arranged with an angle toward one another;
(b) positioning a ceramic conductor plate (18) on the support plates (10, 12) in the initial position such that a weakening line (20), along which breaking should occur, is essentially above the breaking line (14);
(c) breaking the ceramic conductor plate (18) by lowering a breaking knife (52, 8) essentially aligned with the weakening line (20) against the weakening line (20) and against a predetermined force of the support plates (10, 12) and thereby downwardly displacing the support plates (10, 12) into the breaking position;
(d) raising the breaking knife (52, 8);
**characterized by** the following steps:
(e) upwardly displacing at least one of the breaking line ends (54, 56) of the support plates (10, 12) adjacent to the breaking line (14) such that the support plates (10, 12) are arranged such that a fragment of the ceramic plate is exposed for sliding aside;
(f) sliding aside the exposed fragment (38);
(g) returning the support plates (10, 12) in the initial position;
(h) positioning the ceramic conductor plate (18) on the support plates (10, 12) such that a further weakening line (20), along which breaking should occur, is essentially above the breaking line (14); and
(i) repeating the steps (c) to (h) until the ceramic conductor plate is broken along the breaking lines (20), along which breaking should occur.

16. Method according to claim 15, wherein the step (e) comprises displacing the breaking line ends (54, 56) of the support plates (10, 12) upwardly into a gripping position to enlarge the gap between the fragments (38, 18) of a ceramic conductor plate (18).

17. Method according to claim 16, further comprising gripping into the gap between the fragments (38, 18) and sliding aside one of the fragments (38).

18. Method according to one of claims 13 to 17, wherein the movements of the support plates (10, 12) are performed synchronously.

19. Method according to one of claims 13 to 18 comprising the step of retarding the ceramic conductor plate (18) after positioning.

## Revendications

1. Dispositif de fractionnement (2) destiné à séparer des plaques de circuits imprimés en céramique (18) le long de lignes d'affaiblissement (20) sur une plaque de circuits imprimés en céramique (18), présentant un piège de fractionnement (4, 6) avec des plaques d'appui déplaçables l'une par rapport à l'autre (10, 12), qui peuvent être déplacées d'une position de départ, dans laquelle les plaques d'appui (10, 12) sont contiguës sur une ligne de fractionnement (14) et forment une surface d'appui sensiblement plane (16), à une position de fractionnement, dans laquelle les plaques d'appui (10, 12) sont agencées selon un certain angle l'une par rapport à l'autre et un dispositif de retenue (52, 8) conformé de manière à positionner la plaque de circuits imprimés en céramique (18) contre les plaques d'appui (10, 12) pour une opération de fractionnement, le piège de fractionnement (4, 6) présentant deux plaques d'appui (10, 12) qui sont contiguës sur une ligne de fractionnement (14), dans lequel les plaques d'appui (10, 12) de la ligne de fractionnement (14) présentent des extrémités de lignes de fractionnement voisines (54, 56), dans lequel le dispositif de retenue (52, 8) présente une zone d'engagement (58, 60) longitudinale et étroite transversalement à la direction longitudinale,
dans lequel le dispositif de fractionnement (2) présente un élément de positionnement (44) conformé de manière à pouvoir positionner les lignes d'affaiblissement (20) l'une après l'autre en alignement avec la ligne de fractionnement (14) et au-dessus de celle-ci, **caractérisé en ce qu'**au moins une extrémité de ligne de fractionnement (54, 56) des plaques d'appui (10, 12) du piège de fractionnement (4, 6) peut être déplacée vers le haut, les plaques d'appui (10, 12) sont agencées de sorte qu'un fragment de la plaque en céramique soit exposé pour être écarté et dans lequel le dispositif de fractionnement présente en outre un élément de transport conformé de manière à pouvoir être agencé dans des conditions de fonctionnement normales à proximité du bord du fragment exposé (38) de la plaque de circuits imprimés en céramique (18) et être donc déplacé pour écarter le fragment (38).

2. Dispositif de fractionnement (2) selon la revendication 1, **caractérisé en ce que** l'élément de positionnement (44) est l'élément de transport.

3. Dispositif de fractionnement (2) selon la revendication 1 ou 2, **caractérisé en ce que** le piège de fractionnement (4, 6) est conformé de manière à pouvoir déplacer les extrémités des lignes de fractionnement (54, 56) au choix en position de fractionnement vers le haut ou en position de fractionnement vers le bas.

4. Dispositif de fractionnement (2) selon l'une quelconque des revendications 1 à 3, **caractérisé en ce que** la zone d'engagement (58, 60) du dispositif de retenue (52, 8) est agencée sensiblement parallèle à la ligne de fractionnement (14).

5. Dispositif de fractionnement (2) selon l'une quelconque des revendications 1 à 4, **caractérisé en ce que** le dispositif de retenue (52, 8) présente deux zones d'engagement parallèles (58, 60).

6. Dispositif de fractionnement (2) selon la revendication 5, **caractérisé en ce que** les zones d'engagement (58, 60) sont déplaçables l'une par rapport à l'autre.

7. Dispositif de fractionnement (2) selon l'une quelconque des revendications 1 à 5, **caractérisé en ce que** le dispositif de retenue (52, 8) présente une lame de fractionnement (8) qui est raccordée au dispositif de fractionnement (2) de sorte qu'elle soit placée au-dessus de la ligne de fractionnement (14) et puisse être déplacée dans la direction de la ligne de fractionnement (14) jusqu'à celle-ci et au-delà, dans lequel les plaques d'appui (10, 12) sont agencées de manière suffisamment flexible pour que les extrémités des lignes de fractionnement (54, 56) des plaques d'appui (10, 12) se déplacent au-delà de la ligne de fractionnement (14) vers le bas dans la position de fractionnement au cours du déplacement de la lame de fractionnement (8) vers le bas.

8. Dispositif de fractionnement (2) selon l'une quelconque des revendications 1 à 7, présentant en outre un dispositif de couplage (30) qui est raccordé aux plaques d'appui (10, 12) du piège de fractionnement (4, 8) de manière à synchroniser les déplacements des plaques d'appui (10, 12).

9. Dispositif de fractionnement (2) selon l'une quelconque des revendications 1 à 8, **caractérisé en ce qu'**il est prévu une commande qui coordonne les déplacements du piège de fractionnement (46) avec les déplacements des autres éléments (52, 8, 44) du dispositif de fractionnement (2) et présente une interface de saisie via laquelle on peut saisir les mesures des plaques de circuits imprimés en céramique à séparer (18) et la position et/ou les distances des lignes d'affaiblissement ménagées dessus (20) et/ou la direction de fractionnement.

10. Dispositif de fractionnement (2) selon l'une quelconque des revendications 1 à 8, **caractérisé en ce qu'**il est prévu un dispositif de freinage (42) pour la plaque de circuit imprimé en céramique (18).

11. Dispositif de fractionnement (2) selon l'une quelconque des revendications 1 à 10, **caractérisé en ce qu'**il est prévu un dispositif de rotation au moyen duquel, dans des conditions de fonctionnement normales, on peut faire tourner la plaque de circuits imprimés en céramique à usiner (18) et/ou ses fragments (38) autour d'un axe qui est perpendiculaire aux plaques d'appui (10,12).

12. Dispositif de fractionnement (2) selon l'une quelconque des revendications 1 à 11, **caractérisé en ce qu'**il est prévu un deuxième piège de fractionnement (6) qui est agencé dans le dispositif de fractionnement (2) de sorte que sa ligne de fractionnement (14), vue dans le plan des plaques d'appui (10, 12), soit agencée sous un certain angle par rapport à la ligne de fractionnement du premier piège de fractionnement (4).

13. Procédé pour séparer des plaques de circuits imprimés en céramique (18) le long de lignes d'affaiblissement (20) sur une plaque de circuits imprimés en céramique (18), présentant les étapes consistant à :
(a) préparer un piège de fractionnement (4, 6) avec deux plaques d'appui déplaçables l'une par rapport à l'autre (10, 12) qui peuvent être déplacées d'une position de départ, dans laquelle les plaques d'appui (10, 12) sont contiguës sur une ligne de fractionnement (14) et forment une surface d'appui sensiblement plane (16), à une position de fractionnement, dans laquelle les deux plaques d'appui (10, 12) sont agencées sous un certain angle l'une par rapport à l'autre,
(b) positionner une plaque de circuits imprimés en céramique (18) sur les plaques d'appui (10, 12) en position de départ de sorte qu'une ligne d'affaiblissement (20) le long de laquelle le fractionnement est prévu, se situe sensiblement au-dessus de la ligne de fractionnement (14) ;
(c) abaisser un dispositif de retenue (52) qui présente deux zones d'engagement longitudinales (58, 60) sur la plaque de circuits imprimés en céramique (18) de sorte que celles-ci exercent, dans la zone de deux lignes d'affaiblissement (20) qui sont voisines de la ligne d'affaiblissement (20) le long de laquelle le fractionnement est prévu, une force de retenue sur la plaque de circuits imprimés en céramique (18) ;
(d) fractionner la plaque de circuits imprimés en céramique (18) en soulevant les extrémités des lignes de fractionnement (54, 56) des plaques d'appui (10, 12) du piège de fractionnement (4, 6) vers le haut en position de fractionnement ; et
(e) soulever le dispositif de retenue (52) et libérer les fragments (38) de la plaque de circuits imprimés en céramique (18) ;
**caractérisé par** les étapes consistant à :
(f) s'engager dans la fente entre les fragments (38, 18) et écarter l'un des fragments ;
(g) redéplacer les plaques d'appui (10, 12) en position de départ ;
(h) positionner la plaque de circuits imprimés en céramique (18) sur les plaques d'appui (10, 12) de sorte qu'une autre ligne d'affaiblissement (20), le long de laquelle le fractionnement est prévu, se situe sensiblement au-dessus de la ligne de fractionnement (14) ; et
(i) répéter les étapes (c) à (h) jusqu'à ce que la plaque de circuits imprimés en céramique (18) ait été fractionnée le long des lignes d'affaiblissement (20) le long desquelles le fractionnement est prévu.

14. Procédé selon la revendication 13, comprenant en outre l'étape de déplacement des extrémités des lignes de fractionnement (54, 56) des plaques d'appui (10, 12) vers le haut en position de préhension pour agrandir la fente entre les fragments.

15. Procédé pour séparer des plaques de circuits imprimés en céramique (18) le long de lignes d'affaiblissement (20) sur une plaque de circuits imprimés en céramique (18), présentant les étapes consistant à :
(a) préparer un piège de fractionnement (4, 6) avec deux plaques d'appui déplaçables l'une par rapport à l'autre (10, 12), qui peuvent être déplacées d'une position de départ, dans laquelle les plaques d'appui (10, 12) sont contiguës sur une ligne de fractionnement (14) et forment une surface sensiblement plane (16), à une position de fractionnement, dans laquelle les deux plaques d'appui (10, 12) sont agencées sous un certain angle l'une par rapport à l'autre ;
(b) positionner une plaque de circuits imprimés en céramique (18) sur les plaques d'appui (10, 12) en position de départ de sorte qu'une ligne d'affaiblissement (20), le long de laquelle le fractionnement est prévu, se situe sensiblement au-dessus de la ligne de fractionnement (14) ;
(c) fractionner la plaque de circuits imprimés en céramique (18) en abaissant une lame de fractionnement (52, 8), qui est alignée sensiblement sur la ligne d'affaiblissement (20), contre la ligne d'affaiblissement (20) et contre une force prédéterminée des plaques d'appui (10, 12) tout en déplaçant vers le bas les plaques d'appui (10,12) en position de fractionnement ;
(d) soulever la lame de fractionnement (52, 8) ;
**caractérisé par** les étapes consistant à :
(e) déplacer au moins l'une des extrémités des lignes de fractionnement (54, 56) des plaques d'appui (10, 12), voisines des lignes de fractionnement, vers le haut de manière à agencer les plaques d'appui (10, 12) afin qu'un fragment de la plaque en céramique soit exposé à un écartement ;
(f) écarter le fragment exposé (38) ;
(g) redéplacer les plaques d'appui (10, 12) en position de départ ;
(h) positionner la plaque de circuits imprimés en céramique (18) sur les plaques d'appui (10, 12) de sorte qu'une autre ligne d'affaiblissement (20), le long de laquelle le fractionnement est prévu, se situe sensiblement au-dessus de la ligne de fractionnement (14) ; et
(i) répéter les étapes (c) à (h) jusqu'à ce que la plaque de circuits imprimés en céramique ait été fractionnée le long des lignes d'affaiblissement (20), le long desquelles le fractionnement est prévu.

16. Procédé selon la revendication 15, dans lequel l'étape (e) comprend le déplacement des extrémités de lignes de fractionnement (54, 56) des plaques d'appui (10, 12) vers le haut en position de préhension pour agrandir la fente entre les fragments (38, 18) d'une plaque de circuits imprimés en céramique (18).

17. Procédé selon la revendication 16, présentant en outre l'engagement dans la fente entre les fragments (38, 18) et l'écartement d'un des fragments (38).

18. Procédé selon l'une quelconque des revendications 13 à 17, dans lequel les déplacements des plaques d'appui (10,12) sont réalisés de manière synchrone.

19. Procédé selon l'une quelconque des revendications 13 à 18, présentant l'étape de freinage de la plaque de circuits imprimés en céramique (18) après le positionnement.
